(19) Europäisches Patentamt
European Patent Office
Office européen des brevets

(11) **EP 3 923 266 B1**

(12) **EUROPÄISCHE PATENTSCHRIFT**

(45) Veröffentlichungstag und Bekanntmachung des Hinweises auf die Patenterteilung:
**06.08.2025 Patentblatt 2025/32**

(21) Anmeldenummer: **21174923.9**

(22) Anmeldetag: **20.05.2021**

(51) Internationale Patentklassifikation (IPC):
**G09G 3/20** (2006.01)   **G09G 3/32** (2016.01)
**G09G 3/36** (2006.01)

(52) Gemeinsame Patentklassifikation (CPC):
**G09G 3/20;** G09G 3/32; G09G 3/36;
G09G 2320/0257; G09G 2320/046;
G09G 2320/0693; G09G 2380/10

(54) **VERFAHREN ZUR BESTIMMUNG DES RELAXATIONSBEGINNS NACH EINEM BILDEINBRENNVORGANG AN PIXELWEISE ANSTEUERBAREN OPTISCHEN ANZEIGEVORRICHTUNGEN**

METHOD FOR DETERMINING THE ONSET OF RELAXATION ACCORDING TO AN IMAGE BURN-IN PROCESS BASED ON PIXEL-BY-PIXEL CONTROLLABLE OPTICAL DISPLAY DEVICES

PROCÉDÉ DE DÉTERMINATION DU DÉBUT DE LA DÉTENTE APRÈS UN PROCESSUS D'AMORÇAGE D'IMAGE SUR DES DISPOSITIFS D'AFFICHAGE OPTIQUE POUVANT ÊTRE COMMANDÉS AU MOYEN D'UNE COMMANDE MATRICIELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.06.2020 DE 102020207184**

(43) Veröffentlichungstag der Anmeldung:
**15.12.2021 Patentblatt 2021/50**

(73) Patentinhaber: **TechnoTeam Holding GmbH 98693 Ilmenau (DE)**

(72) Erfinder:
• **KRÜGER, Udo**
**99837 Werra-Suhl-Tal OT Wünschensuhl (DE)**
• **ROTSCHOLL, Ingo**
**64289 Darmstadt (DE)**
• **POSCHMANN, Ralf**
**99338 Plaue (DE)**
• **PORSCH, Tobias**
**99092 Erfurt (DE)**

(74) Vertreter: **Liedtke & Partner Patentanwälte Gerhart-Hauptmann-Straße 10/11 99096 Erfurt (DE)**

(56) Entgegenhaltungen:
CN-A- 110 376 218     US-A1- 2003 214 586
US-A1- 2007 222 860

• ROTSCHOLL INGO ET AL: "50-3: Aspects of Image Sticking Evaluations Using Imaging Luminance Measurement Devices", SID SYMPOSIUM DIGEST OF TECHNICAL PAPERS, vol. 50, no. 1, 1 June 2019 (2019-06-01), US, pages 695 - 698, XP055814648, ISSN: 0097-966X, DOI: 10.1002/sdtp.13014

**Beschreibung**

Die Erfindung betrifft ein Verfahren zur Bestimmung des Relaxationsbeginns an einer pixelweise ansteuerbaren optischen Anzeigevorrichtung, welche einem Einbrennvorgang ausgesetzt war. Die Erfindung betrifft ferner ein Verfahren und eine Vorrichtung zur Bestimmung des Einbrennverhaltens an einer solchen Anzeigevorrichtung sowie die Anwendung eines solchen Verfahrens für die Bestimmung des Einbrennverhaltens von Displays, welche in Fahrzeugen eingesetzt werden.

Elektronisch pixelweise ansteuerbare optische Anzeigevorrichtungen, insbesondere Displays, können eine als Einbrennen bezeichnete Veränderung eines dargestellten Bildes aufweisen. Ein Einbrennen kann durch längere, unveränderte Darstellung eines Bildes auf der Anzeigevorrichtung bewirkt werden. Wird die Anzeigevorrichtung unmittelbar nach der Darstellung eines derart eingebrannten Bildes mit einem demgegenüber geänderten Anzeigebild angesteuert, so kann das dargestellte Bild Merkmale und Strukturen des zuvor dargestellten Einbrennbildes aufweisen. Derartige Einbrenneffekte werden auch als Geisterbild, Image Sticking, Image Retention oder Burn-In bezeichnet.

Das Anzeigebild erscheint nach einem Einbrennen verändert gegenüber einer Darstellung des gleichen Anzeigebildes auf einer Anzeigevorrichtung, die keinem Einbrennen ausgesetzt war, wobei der Unterschied mit der Zeitdauer der Darstellung des Anzeigebildes abnehmen kann. In vielen Fällen kann der Zeitverlauf der durch das Einbrennen bewirkten Störung S(t) durch eine abklingende Exponentialfunktion $S(t) = S_0 \cdot e^{-\frac{t}{\tau}}$ genähert werden. Die Störung $S_0$, die unmittelbar nach dem Umschalten der Anzeigevorrichtung vom Einbrennbild auf das Anzeigebild beobachtet wird, kann beispielsweise über einen skalaren Faktor $\alpha$ auf ein nach dem Einbrennen an der Anzeigevorrichtung dargestelltes Referenzbild $B0$ bezogen sein, das heißt: $S_0 = (1 + \alpha) \cdot B0$. Die Zeitkonstante $\tau$ der exponentiell abklingenden Störung wird als Relaxationszeitkonstante bezeichnet.

Die durch das Einbrennen bewirkte Störung kann je nach Technologie der Anzeigevorrichtung die Leuchtdichte und/oder die Farbe des dargestellten Bildes betreffen. Ein Einbrennverhalten ist von Displays, insbesondere von LCD (liquid crystal display) - Displays und von OLED (organic light emitting diode) - Displays bekannt. Auch von Displays und projizierenden Anzeigevorrichtungen, die auf einer DMD (digital mirror device) Technologie beruhen, ist ein Einbrennverhalten bekannt. Es können aber auch weitere, nach anderen physikalischen Prinzipien arbeitende Displays und projizierende Anzeigevorrichtungen von einem derartigen Einbrennverhalten betroffen sein.

Es ist auch möglich, dass die durch ein Einbrennen bewirkte Störung nicht vollständig abklingt, insbesondere nach einem sehr langen Einwirken eines Einbrennbildes über viele Stunden oder Wochen hinweg.

Aus dem Stand der Technik bekannte Verfahren zur Bestimmung des Einbrennverhaltens steuern eine Anzeigevorrichtung mit einem Testbild an und vermessen die von der Anzeigevorrichtung abgegebene Leuchtdichteverteilung. Danach wird die Anzeigevorrichtung für eine vorbestimmte Zeit, beispielsweise einige Minuten, Stunden oder auch mehrere Tage, mit einem Einbrennbild angesteuert und dadurch ein Einbrennen provoziert. Unmittelbar danach wird die Anzeigevorrichtung erneut mit dem Testbild angesteuert und die abgegebene Leuchtdichteverteilung vermessen, die sich unter der Wirkung des Einbrennens von der ursprünglich (vor dem Einbrennen) vermessenen Leuchtdichteverteilung unterscheidet.

Es sind Vorrichtungen und Verfahren sowohl zur scannenden (das heißt: punktweise abtastenden) als auch zur flächigen Vermessung einer Leuchtdichteverteilung bekannt. Insbesondere sind Leuchtdichtemesskameras bekannt, mit denen die Ortsverteilung einer fotometrischen Kenngröße, vorzugsweise einer von einer Anzeigevorrichtung emittierten Leuchtdichte, vermessen werden kann.

Der Unterschied der Leuchtdichteverteilungen kann als Quotient oder als Differenz erfasst werden. Auch eine Mehrzahl von Unterschieden kann erfasst werden, indem ein Zeitverlauf der vom Display nach dem Einbrennvorgang emittierten Darstellung des Testbildes hinsichtlich der Leuchtdichteverteilung vermessen wird.

Für eine quantitative Bestimmung sowohl der Einbrennwirkung als auch der Erholung einer Anzeigevorrichtung (das heißt: des Abklingens der durch das Einbrennen bewirkten Störung der Darstellung) ist es erforderlich, den Messzeitpunkt einer Leuchtdichteverteilung auf den Zeitpunkt zu beziehen, an welchem das Einbrennbild abgeschaltet und das Testbild angeschaltet wurde, und der nachfolgend als Relaxationsbeginn bezeichnet werden soll.

Es sind Verfahren bekannt, bei denen die Messung der Leuchtdichteverteilung durch Aufnahme eines Kamerabildes einer Leuchtdichtemesskamera zeitlich versetzt zur Ansteuerung der Anzeigevorrichtung mit dem Testbild erfolgt. Beispielsweise kann mittels eines Computers über einen Grafikausgang zunächst die Ansteuerung der Anzeigevorrichtung vom Einbrennbild auf das Testbild umgeschaltet werden und danach, nach einer vorbestimmten Wartezeit, die Aufnahme des Kamerabildes an der Leuchtdichtemesskamera ausgelöst werden.

Es ist auch bekannt, dass die Umschaltung des von der Anzeigevorrichtung dargestellten Bildes nicht synchron zum Umschalten vom Einbrennbild auf das Testbild, sondern verzögert dazu erfolgt. Die Verzögerung hängt unter anderem von der Technologie der Anzeigevorrichtung und von dem Typ des Grafikausgangs ab, der vom Computer für die Ansteuerung der Anzeigevorrichtung genutzt wird. Diese Verzögerung ist im Allgemeinen nicht genau bekannt oder nur mit zusätzlichem Aufwand bestimmbar. Diese Verzögerung kann variabel sein, so dass eine Mehrzahl von Messungen verschiedene Werte für die Verzögerung ergeben kann.

Es ist auch möglich, dass die Umschaltung vom Einbrennbild auf das Testbild nicht für alle Bildpixel synchron erfolgt, so dass einige Bildpixel bereits den dem Testbild zugeordneten Pixelwert darstellen, während andere Bildpixel noch den dem Einbrennbild zugeordneten Pixelwert darstellen.

Zudem ist der Zeitpunkt, zu dem eine Aufnahme an einer Leuchtdichtemesskamera ausgelöst werden kann, im Allgemeinen nicht synchron zum Umschalten des dargestellten Bildes, sondern mit einer fluktuierenden Abweichung (Jitter) versehen.

Zur Quantifizierung der Einbrennwirkung ist es vorteilhaft, mindestens eine Leuchtdichteverteilung unmittelbar nach dem Umschalten des von der Anzeigevorrichtung tatsächlich dargestellten Bildes zu erfassen.

Aufgrund der nicht genau bekannten wirksamen Umschaltverzögerung und des Jitters besteht einerseits die Gefahr, eine Aufnahme eines Kamerabildes an der Leuchtdichtemesskamera bereits vor der Umschaltung des dargestellten Einbrennbildes in das Testbild auszulösen. In diesem Fall erfolgt die Belichtung der Leuchtdichtemesskamera mindestens über einen Teil der Belichtungszeit hinweg mit dem Einbrennbild. Dadurch wird die Wirkung des Einbrennens überschätzt.

Andererseits besteht die Gefahr eines relativ zum Umschalten der Anzeigevorrichtung verspäteten Auslösens der Leuchtdichtemesskamera. In diesem Fall wird eine Leuchtdichteverteilung der Anzeigevorrichtung in einem bereits teilweise erholten Zustand aufgenommen. Dadurch wird die Wirkung des Einbrennens unterschätzt.

Aus der Veröffentlichung Rotscholl, Ingo; Krüger, Udo (2019): 50-3: Aspects of Image Sticking Evaluations Using Imaging Luminance Measurement Devices. In: SID Symposium Digest of Technical Papers 50 (1), S. 695-698. DOI: 10.1002/sdtp.13014 sind ein Verfahren und eine Vorrichtung bekannt, bei denen mittels eines von einer Leuchtdichtemesskamera unabhängigen externen Messgeräts eine fotometrische Kenngröße an einem Display erfasst wird. Variiert das von dem Display dargestellte Bild, beispielsweise beim Umschalten von einem Einbrennbild auf ein Testbild, so variiert auch die von dem externen Messgerät erfasste fotometrische Kenngröße. Durch Vergleich der gemessenen fotometrischen Kenngröße mit einem vorbestimmten, insbesondere anhand des Einbrennbildes, des Testbildes, des von dem externen Messgerät erfassten Displayausschnitts und der Integrationszeit für die Messung ermittelten Schwellwert kann der Relaxationsbeginn, das heißt: das Umschalten von der Darstellung des Einbrennbildes zur Darstellung des Testbildes, genauer bestimmt werden. Dadurch ist es möglich, die Aufnahme einer Leuchtdichteverteilung relativ zur Erholungsdauer oder Relaxationsdauer des vermessenen Displays genauer auszulösen oder rechnerisch genauer in Bezug zu setzen, beispielsweise zur Bestimmung einer Relaxationszeitkonstante.

Das Dokument Lee, Don-Gyou et .al.: The Analysis Method of Dynamic Characteristics in LCD. In: SID Symposium Digest of Technical Papers, 2003, S. 292-295 beschreibt ein Verfahren zur Analyse dynamischer Verzögerungsphänomene bei Liquid Crystal Display (LCD) - Anzeigen. Bei dem Verfahren wird eine Hochgeschwindigkeits - Charged Coupled Device (CCD) - Kamera mit einer Auflösung von 480 x 420 Pixeln und einem Dynamikumfang von 8 Bit eingesetzt, die eine LCD - Anzeige mit einer optischen Vorrichtung erfasst. Zur Objektivierung eines Maßes für eine dynamische Verzögerung wird ein als Dynamic Delay Contrast (DDC) Ratio bezeichneter Parameter vorgeschlagen.

Das Dokument CN 110 376 218 A beschreibt ein Verfahren und eine Vorrichtung zur Erkennung von Geisterbildern auf Anzeigevorrichtungen. Gemäß dem Verfahren wird auf der Anzeigevorrichtung ein erstes Bild mit einem vorbestimmten identifizierenden Code umfassend einen ersten und einen zweiten Grauwert dargestellt und danach auf ein zweites Bild mit einem dritten Grauwert umgeschaltet, der zwischen dem ersten und dem zweiten Grauwert liegt. Mit einer Bilderfassungseinrichtung wird fortlaufend das dargestellte zweite Bild erfasst. Es wird der Zeitpunkt ermittelt, bis zu dem der identifizierende Code des ersten Bildes detektiert werden kann.

Das Dokument US 2003/0214586 A1 beschreibt ein Verfahren und eine Vorrichtung zur quantitativen Bestimmung der Bildqualität eines von einer Anzeigevorrichtung dargestellten Bildes.

Das Dokument US 2007/0222860 A1 beschreibt eine Vorrichtung zur Korrektur des Einbrennens von Bildern auf einem Display. Die Vorrichtung umfasst eine Bilderfassungseinheit, mit der von dem Display dargestellte Bilder erfasst werden, sowie eine Lichtsteuerungseinheit, mit der einzelne Pixel des Displays zur Wiedergabe eines vorbestimmten Leuchtwertes angesteuert werden. Mit der Bilderfassungseinheit wird der Luminanzunterschied bei der Wiedergabe des vorbestimmten Leuchtwertes pixelbezogen erfasst. Mit einer Recheneinheit wird der erfasste Luminanzunterschied mit dem vorbestimmten Leuchtwert verglichen und aus der daraus ermittelten Differenz eine Korrektur ermittelt.

Der Erfindung liegt die Aufgabe zu Grunde, ein verbessertes Verfahren zur Bestimmung des Relaxationsbeginns an einer pixelweise ansteuerbaren optischen Anzeigevorrichtung, die einem Einbrennvorgang ausgesetzt war, anzugeben, das besonders einfach und mit geringem gerätetechnischen Aufwand umsetzbar ist. Diese Aufgabe wird erfindungsgemäß durch ein Verfahren mit den Merkmalen des Anspruchs 1 gelöst.

Ferner liegt der Erfindung die Aufgabe zu Grunde, ein Verfahren zur Bestimmung des Einbrennverhaltens einer pixelweise ansteuerbaren optischen Anzeigevorrichtung anzugeben. Diese Aufgabe wird erfindungsgemäß durch ein Verfahren mit den Merkmalen des Anspruchs 5 gelöst.

Ferner liegt der Erfindung die Aufgabe zu Grunde, eine Vorrichtung zur Bestimmung des Einbrennverhaltens einer pixelweise ansteuerbaren optischen Anzeigevorrichtung anzugeben. Diese Aufgabe wird erfindungsgemäß durch eine Vorrichtung mit den Merkmalen des Anspruchs 10 gelöst.

Ferner liegt der Erfindung die Aufgabe zu Grunde, eine Anwendung eines Verfahrens zur Bestimmung des Einbrennverhaltens einer pixelweise ansteuerbaren optischen Anzeigevorrichtung anzugeben. Diese Aufgabe wird erfindungsgemäß durch eine Anwendung mit den Merkmalen des Anspruchs 12 gelöst.

Vorteilhafte Ausgestaltungen der Erfindung sind Gegenstand der Unteransprüche.

Bei einem Verfahren zur Bestimmung eines Relaxationsbeginns einer Relaxation, welche nach dem Umschalten einer pixelweise ansteuerbaren optischen Anzeigevorrichtung von einem Einbrennbild auf ein davon verschiedenes Relaxationsbild einsetzt, wird in dem Einbrennbild erfindungsgemäß ein Triggerbildbereich umfassend mindestens einen Bildpixel derart mit Pixelwerten belegt, dass ein aus dem mindestens einen Pixelwert im Triggerbildbereich des Einbrennbildes gebildeter erster Parameter sich von einem aus dem mindestens einen Pixelwert im Triggerbildbereich des Relaxationsbildes gebildeten zweiten Parameter unterscheidet.

Beispielsweise können der erste und der zweite Parameter als Summe oder als Mittelwert einer Mehrzahl von Pixelwerten des Triggerbildbereichs im Einbrennbild beziehungsweise im Relaxationsbild bestimmt werden.

Der Triggerbildbereich kann auch mehrere Bildpixel umfassen. Die dem Triggerbildbereich zugeordneten Bildpixel können dann zusammenhängend angeordnet sein. Es ist aber auch möglich, in einem Triggerbildbereich mehrere nicht zusammenhängende Triggerbildteilbereiche zusammenzufassen, deren Bildpixel dann derart mit Pixelwerten belegt werden, dass eine über alle Triggerbildteilbereiche gebildete Summe oder ein über alle Triggerbildteilbereiche gebildeter Mittelwert von Pixelwerten sich von der Summe beziehungsweise von dem Mittelwert der Pixelwerte der korrespondierend zu den Triggerbildteilbereichen im Relaxationsbild angeordneten Bildpixel unterscheidet.

Einbrennbild und Relaxationsbild sind gleich groß, das heißt: weisen gleiche Pixelabmessungen auf, unterscheiden sich jedoch in den Pixelwerten. Der Triggerbildbereich kann beispielsweise als rechteckiger oder quadratischer Teilbereich ausgebildet sein. Der Triggerbildbereich liegt bezüglich der Pixelabmessungen im Einbrennbild und im Relaxationsbild gleich.

Mittels einer Kamera umfassend ein Sensorfeld von Sensorpixeln wird die örtliche Verteilung eines Grauwertes zeitlich fortlaufend erfasst. Die Kamera ist zum Auslesen der Gesamtheit aller Sensorpixel mit einer Kamerataktrate eingerichtet.

Es wird ein Triggerteilfeld von Sensorpixeln derart festgelegt, dass das Triggerteilfeld den Triggerbildbereich eines auf der Anzeigevorrichtung dargestellten Anzeigebildes überlappt.

Mit einer Triggertaktrate wird zeitlich fortlaufend ein Triggerkennwert aus den Pixelwerten der Sensorpixel in dem Triggerteilfeld bestimmt. Der Triggerkennwert kann beispielsweise als Summe oder als Mittelwert aller Pixelwerte der Sensorpixel in dem Triggerteilfeld bestimmt werden; es sind aber auch andere, beispielsweise statistische Maße für die Bestimmung des Triggerkennwerts möglich.

Der Verlauf des von den Sensorpixeln erfassten Grauwertes entspricht dem Verlauf der örtlichen Verteilung einer fotometrischen Kenngröße, beispielsweise einer Leuchtdichte, über der Anzeigevorrichtung insoweit, als eine zeitliche Änderung einer solchen fotometrischen Kenngröße in dem Triggerbildbereich eines auf der Anzeigevorrichtung dargestellten Anzeigebildes eine zeitliche Änderung eines aus den Pixelwerten der Sensorpixel in dem Triggerteilfeld bestimmten Triggerkennwertes bewirkt.

In einer Ausführungsform ist die Kamera als Leuchtdichtemesskamera ausgebildet und zur Erfassung der örtlichen Verteilung einer fotometrischen Kenngröße eingerichtet.

Es wird ein Triggerschwellwert bestimmt, der zwischen dem Triggerkennwert, der sich für die Aufnahme des Einbrennbildes ergibt, und dem Triggerkennwert, der sich für die Aufnahme des Relaxationsbildes ergibt, liegt.

Der Relaxationsbeginn wird als derjenige Zeitpunkt ermittelt, zu dem der fortlaufend ermittelte Triggerkennwert den Triggerschwellwert überstreicht, beispielsweise erstmalig überschreitet oder erstmalig unterschreitet.

Ein Vorteil des Verfahrens besteht darin, dass es unabhängig von der nicht genau bestimmbaren Latenz zwischen der Ansteuerung der Anzeigevorrichtung und dem Umschalten der Darstellung der Anzeigevorrichtung arbeitet. Dadurch kann der Relaxationszeitpunkt, zu dem die Erholung (Relaxation) der Anzeigevorrichtung von der Wirkung des Einbrennbildes einsetzt, genauer bestimmt werden. Ein weiterer Vorteil des Verfahrens besteht darin, dass es keiner zusätzlichen, über die Kamera hinausgehenden Mittel bedarf. Zudem können Latenzen und Jitter, die bei Ansteuerung der Kamera durch solche zusätzlichen Mittel unvermeidbar auftreten, vermieden werden.

Bei einer Ausführungsform des Verfahrens wird die Triggertaktrate höher gewählt als die für das Auslesen der Sensorpixel des Sensorfeldes der Kamera vorgesehene Kamerataktrate. Ein Vorteil dieser Ausführungsform besteht darin, dass der Relaxationszeitpunkt genauer bestimmt werden kann, als dies durch Auswertung der von der Kamera gelieferten Einzelbilder möglich ist.

Es ist möglich, die Triggertaktrate gegenüber der Kamerataktrate dadurch zu erhöhen, dass nur Teilbereiche des Sensorfeldes in einer Form ausgelesen werden, die für eine Bestimmung des Triggerkennwertes ausreichend und geeignet ist. Beispielsweise ist es möglich, durch Sensorpixelbinning eine Mehrzahl benachbarter Sensorpixel zusammenzufassen und als einen einzigen Wert auszulesen, der der Summe oder dem Mittelwert aller zusammengefassten Sensorpixel entspricht. Auch Verfahren, bei denen das Sensorfeld der Kamera unterabgetastet wird, indem beispielsweise nur jeder zweite oder jeder vierte, allgemein: jeder n-te Sensorpixel ausgelesen wird, sind möglich. Auch Verfahren, bei denen nur ein als Area of Interest (AOI) bezeichneter Teilbereich des Sensorfeldes der Kamera oder mehrere solcher Teilbereiche ausgelesen werden, sind möglich und führen zu einer erheblichen Erhöhung der Triggertaktrate.

Bei einer Ausführungsform des Verfahrens wird nur ein Teilfeld des Sensorfeldes der Kamera ausgelesen, welches mindestens das Triggerteilfeld umfasst. Die dem Triggerteilfeld und somit auch dem ausgelesenen Teilfeld des Sensorfeldes zugeordneten Sensorpixel können zusammenhängend angeordnet sein. Diese Sensorpixel können aber auch nicht-zusammenhängend über das Sensorfeld verteilt sein. Das ausgelesene Teilfeld des Sensorfeldes kann auf das Triggerteilfeld beschränkt sein. Es kann aber auch noch weitere, zusätzliche Sensorpixel umfassen, die nicht dem Triggerteilfeld zugeordnet sind.

Bei dieser Ausführungsform wird die Triggertaktrate höher als die für das vollständige Auslesen des Sensorfeldes vorgesehene Kamerataktrate gewählt.

Mittels derartiger Verfahren wird erreicht, dass beim Auslesen eines Teilbereiches des Sensorfeldes, der das Triggerteilfeld umfasst, eine geringere Zahl von Werten zu übertragen ist und somit die Triggertaktrate gegenüber der Kamerataktrate erhöht werden kann. Dadurch kann der Relaxationszeitpunkt noch genauer bestimmt werden.

Beispielsweise kann mittels derartiger Verfahren bei einer Kamerataktrate von 20 Hertz eine Triggertaktrate von über 1 Kilohertz und somit eine zeitliche Auflösung bei der Bestimmung des Relaxationszeitpunkts im Millisekundenbereich erreicht werden.

Bei einer Ausführungsform des Verfahrens wird der Triggerkennwert nur in einem Zeitbereich von vorbestimmter Dauer erfasst, der den Zeitpunkt umfasst, zu dem die Ansteuerung der Anzeigevorrichtung von dem Einbrennbild auf das Relaxationsbild umgeschaltet wird. Der Umschaltzeitpunkt, zu dem die Ansteuerung der Anzeigevorrichtung von dem Einbrennbild auf das Relaxationsbild umgeschaltet wird, kann zwar nur ungenau, aber mit geringem technischem Aufwand ermittelt werden. Zur Erzielung einer hohen Genauigkeit bezüglich des Relaxationsbeginns reicht es dann, einen gewissen Zeitbereich vor und/oder nach diesem Umschaltzeitpunkt genauer zu untersuchen. Dadurch kann der Aufwand für die Durchführung des Verfahrens verringert werden.

Bei einer weiteren Ausführungsform des Verfahrens wird aus einer Mehrzahl von Triggerkennwerten, die aufeinanderfolgend in einem Zeitbereich von vorbestimmter Dauer erfasst werden, ein mittlerer Triggerkennwert gebildet und dieser, an Stelle der einzelnen Triggerkennwerte, mit dem Triggerschwellwert verglichen. Der mittlere Triggerkennwert kann durch ein gleitendes Mittel, einen gleitenden Median, einen Tiefpass oder ein ähnliches Signalverarbeitungsverfahren zur Eliminierung hochfrequenter Störungen gebildet werden.

Diese Ausführungsform weist den Vorteil auf, dass Schwankungen in dem zeitlich fortlaufend ermittelten Triggerkennwert, die durch die Helligkeitsmodulation der Anzeigevorrichtung verursacht sein können, eliminiert werden. Beispielsweise können Anzeigevorrichtungen die Helligkeit von Bildpixeln mittels Pulsweitenmodulation steuern und dadurch, je nach zeitlicher Lage der Integrationszeit der Kamera relativ zum Takt der Pulsweitenmodulation, bei gleichem, auf der Anzeigevorrichtung dargestelltem Bildinhalt, variierende Triggerkennwerte erzeugen. Durch die vorgeschlagene Bildung des mittleren Triggerkennwertes wird eine fehlerhafte Detektion des Überstreichens, das heißt: einer Über- oder Unterschreitung des Triggerschwellwertes vermieden.

Bei einer Ausführungsform des Verfahrens werden die Pixelwerte im Triggerbildbereich derart gewählt, dass ein erster Mittelwert von Pixelwerten im Triggerbildbereich des Einbrennbildes höher ist als ein zweiter Mittelwert von Pixelwerten im Triggerbildbereich des Relaxationsbildes. Vorzugsweise werden die Pixelwerte im Triggerbildbereich des Einbrennbildes so gewählt, dass mindestens in einem Teilbereich des Triggerbildbereichs die mit der Anzeigevorrichtung maximal erzielbare Leuchtdichte erzielt wird.

Dadurch kann die Integrations- oder Belichtungszeit, während der der Triggerbildbereich zur Erzielung eines auswertbaren Triggerkennwerts belichtet werden muss, reduziert werden. Dies ermöglicht eine dichtere zeitliche Abfolge (oder Abtastung) des Triggerkennwertes. Dadurch kann der Relaxationsbeginn genauer bestimmt werden.

Bei einem Verfahren zur Bestimmung des Einbrennverhaltens einer pixelweise ansteuerbaren optischen Anzeigevorrichtung wird die Anzeigevorrichtung, wenn sie keinem Einbrennvorgang ausgesetzt war, zur Darstellung eines Referenzbildes angesteuert. Dabei wird mittels einer Kamera ein erstes Kamerabild aufgenommen, das die örtliche Verteilung eines Grauwertes korrespondierend zur örtlichen Verteilung einer fotometrischen Kenngröße über der Anzeigevorrichtung erfasst, während diese zur Darstellung des Referenzbildes angesteuert wird.

Nachfolgend wird die Anzeigevorrichtung für eine vorbestimmte Einbrenndauer zur Darstellung eines Einbrennbildes angesteuert.

Nachfolgend wird die Anzeigevorrichtung zur Darstellung eines Relaxationsbildes angesteuert. Dabei wird mittels der Kamera mindestens ein weiteres Kamerabild aufgenommen, das die örtliche Verteilung eines Grauwertes korrespondierend zur örtlichen Verteilung einer fotometrischen Kenngröße über der Anzeigevorrichtung erfasst, während diese zur Darstellung des Relaxationsbildes angesteuert wird.

Erfindungsgemäß wird ein Relaxationsbeginn mittels der Kamera nach einem der oben beschriebenen Verfahren ermittelt und aus dem ersten Kamerabild, dem mindestens einen weiteren Kamerabild sowie dem Relaxationsbeginn das Einbrennverhalten für die Anzeigevorrichtung ermittelt.

Ein Vorteil dieses Verfahrens besteht darin, dass der Relaxationsbeginn genauer bestimmt werden kann und dadurch auch das Relaxationsverhalten, beispielsweise die Relaxationszeitkonstante, der Anzeigevorrichtung, welches sich aus der auf die Relaxationsdauer bezogenen Störung in dem gemessenen Bild ergibt, ebenfalls genauer bestimmt werden kann. Ein weiterer Vorteil des Verfahrens besteht darin, dass es keiner zusätzlichen, über die Kamera hinausgehenden Mittel bedarf. Dadurch können auch Latenzen und Jitter, die bei Ansteuerung der Kamera durch solche zusätzlichen Mittel unvermeidbar auftreten, vermieden werden. Damit wird eine zuverlässigere und genauere Bewertung des Relaxationsverhaltens der Anzeigevorrichtung ermöglicht.

Bei einer Ausführungsform eines Verfahrens zur Bestimmung des Einbrennverhaltens wird von dem mindestens einen weiteren Kamerabild, welches die örtliche Verteilung eines Grauwertes korrespondierend zur örtlichen Verteilung einer photometrischen Kenngröße über der Anzeigevorrichtung erfasst, während diese zur Darstellung des Relaxationsbildes angesteuert wird, nur ein Teilfeld des Sensorfeldes, also nur ein Teil aller Sensorpixel der Kamera, ausgelesen. Das Auslesen dieses Teilfeldes erfolgt mit einer Auslesetaktrate, die höher als die für das vollständige Auslesen des Sensorfeldes (also für das Auslesen aller Sensorpixel der Kamera) vorgesehene Kamerataktrate gewählt ist.

Dadurch wird erreicht, dass der Verlauf de r fotometrischen Kenngröße während der Darstellung des Relaxationsbildes mit höherer zeitlicher Auflösung erfasst werden kann als bei einem vollständigen Auslesen des mindestens einen weiteren Kamerabildes. Dadurch kann die Genauigkeit bei der Bewertung des Einbrennverhaltens verbessert werden.

Bei einer Ausführungsform wird das Teilfeld, das in dem mindestens einen weiteren Kamerabild während der Darstellung des Relaxationsbildes auf der Anzeigevorrichtung mit der gegenüber der Kamerataktrate erhöhten Auslesetaktrate ausgelesen wird, mindestens teilweise überlappend zu dem zur Ermittlung des Triggerkennwerts genutzten Triggerteilfeld gewählt. Dadurch kann die Implementierung des Verfahrens vereinfacht und der Aufwand zur Herstellung des Bezugs zwischen dem Teilfeld und dem korrespondierenden Bildbereich des Relaxationsbildes verringert werden.

Bei einer Ausführungsform des Verfahrens ist die Kamera als Leuchtdichtemesskamera ausgebildet, mit der eine besonders genaue, insbesondere quantitative Bestimmung des Einbrennverhaltens einer Anzeigevorrichtung möglich ist.

Bei einer Ausführungsform des Verfahrens wird das mindestens eine weitere Kamerabild in einem vorbestimmten zeitlichen Versatz zu dem Zeitpunkt aufgenommen, in welchem der Triggerkennwert den Triggerschwellwert überstreicht.

Für einige Formen von Anzeigevorrichtungen ist bekannt, dass die Umschaltung von einem ersten Bild, beispielsweise dem Einbrennbild, auf ein darauffolgendes zweites Bild, beispielsweise das Relaxationsbild, nicht instantan in dem Zeitpunkt erfolgt, in dem der neue Bildinhalt an die Anzeigevorrichtung übertragen wird. Die Umschaltung erfolgt bei derartigen Anzeigevorrichtungen vielmehr für verschiedene Bildpixel zu unterschiedlichen Zeitpunkten verteilt innerhalb eines Umschaltzeitintervalls, das typischerweise einige Millisekunden bis 100 Millisekunden lang ist. Das Umschaltzeitintervall ist abhängig vom Typ der Anzeigevorrichtung bekannt oder kann ermittelt werden.

Bei der vorliegenden Ausführungsform des Verfahrens wird zur Bestimmung des Relaxationsbeginns zu dem Zeitpunkt, in welchem der Triggerkennwert den Triggerschwellwert überstreicht, ein zeitlicher Versatz addiert, der das bekannte oder zuvor ermittelte Umschaltzeitintervall mindestens abdeckt. Dadurch ist sichergestellt, dass zu dem derart ermittelten Relaxationsbeginn alle Bildpixel (und nicht nur jene des Triggerbildbereichs) den Bildinhalt des Relaxationsbildes anzeigen.

Ein Vorteil dieser Ausführungsform besteht darin, dass die Wirkung des Einbrennens leichter verglichen und bewertet werden kann, wenn Kamerabilder in einem vorbestimmten zeitlichen Abstand zum Relaxationsbeginn aufgenommen und zur Auswertung herangezogen werden. Insbesondere wird dadurch vermieden, dass die Wirkung des Einbrennens fehlerhaft dadurch überschätzt wird, dass ein zu einem zu früh ermittelten Relaxationsbeginn von der Anzeigevorrichtung angezeigtes Bild in Teilen, insbesondere außerhalb des Triggerbildbereichs, noch das Einbrennbild darstellt.

Eine Vorrichtung zur Bestimmung des Einbrennverhaltens einer pixelweise ansteuerbaren optischen Anzeigevorrichtung umfasst eine Steuereinheit und eine Kamera. Die Kamera ist als Complementary Metal-Oxide Semiconductor (CMOS) Kamera ausgebildet. Alternativ kann die Kamera auch als Charge-Coupled Device (CCD) Kamera ausgebildet sein. Die Steuereinheit ist zur Ansteuerung einer pixelweise ansteuerbaren optischen Anzeigevorrichtung eingerichtet. Die Steuereinheit und die Kamera sind erfindungsgemäß zur Durchführung des oben beschriebenen Verfahrens zur Bestimmung des Einbrennverhaltens einer pixelweise ansteuerbaren optischen Anzeigevorrichtung eingerichtet.

Die Kamera kann als intelligente Kamera (Smart Kamera) ausgebildet sein und einen internen Prozessor umfassen, der zur Ausführung von Bildverarbeitungsoperationen und/oder zur Durchführung des oben beschriebenen Verfahrens zur Bestimmung des Einbrennverhaltens einer pixelweise ansteuerbaren optischen Anzeigevorrichtung eingerichtet ist.

Ein Vorteil dieser Vorrichtung besteht darin, dass der Relaxationsbeginn und somit auch das Einbrennverhalten besonders genau und gut reproduzierbar bestimmt werden können. Ein weiterer Vorteil besteht darin, dass der gerätetechnische Aufwand und der Aufwand zur Einrichtung und Kalibrierung der Messvorrichtung gegenüber Messvorrichtungen nach dem Stand der Technik verringert werden kann, welche eine externe, von der Kamera unabhängige Messeinrichtung zur Bestimmung des Relaxationsbeginns einsetzen.

Bei einer Ausführungsform der Vorrichtung ist die Kamera zur fortlaufenden Bestimmung des Triggerkennwertes aus den Pixelwerten der Sensorpixel in dem Triggerteilfeld und zum Vergleich des Triggerkennwertes mit dem Triggerschwellwert eingerichtet.

Ein Vorteil dieser Ausführungsform besteht darin, dass die Bestimmung des Relaxationsbeginns und eine daran gekoppelte Auslösung einer oder mehrerer Kameraaufnahmen autark in der Kamera ausgeführt werden kann. Dadurch kann der Einfluss von Latenzzeiten und Jitter, die bei einem Datenaustausch zwischen der Kamera und dem Computer unvermeidlich auftreten, vermieden oder verringert werden. Somit können die Genauigkeit und die Reproduzierbarkeit bei der Bestimmung des Einbrennverhaltens verbessert werden. Zudem kann der gerätetechnische Aufwand verringert werden, da es keiner externen Messeinrichtungen bedarf.

In einem weiteren Aspekt der Erfindung wird das vorgeschlagene Verfahren zur Bestimmung des Einbrennverhaltens einer pixelweise ansteuerbaren optischen Anzeigevorrichtung für die Bestimmung des Einbrennverhaltens eines Displays eingesetzt, welches für den Einsatz in einem Fahrzeug vorgesehen ist.

In einem Fahrzeug eingesetzte Displays werden über eine besonders lange Betriebsdauer und zu einem besonders hohen Anteil zur Darstellung statischer oder über eine lange Zeit unveränderter Grafiken oder Bilder eingesetzt. Daher kommt der genauen und zuverlässigen Bestimmung von Störungen, die durch solche statischen Bilder bewirkt werden, hier eine besonders große Bedeutung zu. Das vorgeschlagene Verfahren ermöglicht, auf Grund einer genaueren Bestimmung des Relaxationsbeginns, eine zuverlässigere Bewertung von Displays als aus dem Stand der Technik bekannte Verfahren.

Ausführungsbeispiele der Erfindung werden im Folgenden anhand von Zeichnungen näher erläutert. Darin zeigen:

Figur 1    schematisch eine Vorrichtung zur Vermessung des Einbrennverhaltens eines Displays,

Figur 2    schematisch eine bei der Vermessung des Einbrennverhaltens projizierte Abfolge von Bildern,

Figur 3    schematisch eine Vorrichtung zur Vermessung des Einbrennverhaltens eines Displays,

Figur 4    schematisch ein Sensorfeld einer CMOS-Kamera sowie

Figur 5    schematisch den Verlauf eines zu einem Triggerbildbereich korrespondierenden Tiggerintegralwerts.

Einander entsprechende Teile sind in allen Figuren mit den gleichen Bezugszeichen versehen.

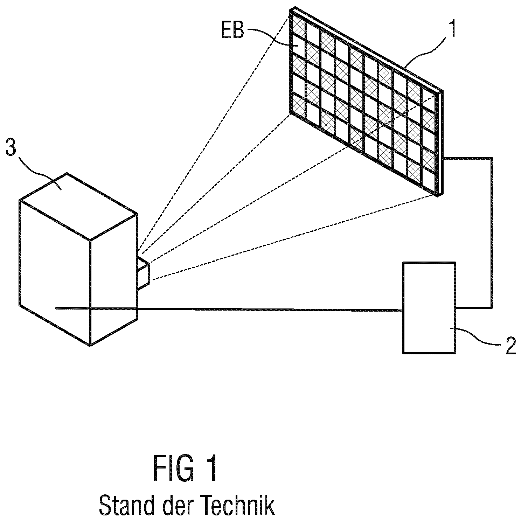

Figur 1 zeigt schematisch einen aus dem Stand der Technik bekannten Messaufbau zur Vermessung des Einbrennverhaltens eines Displays 1. Der Messaufbau umfasst einen Computer 2, der mit dem Display 1 sowie mit einer Kamera 3 verbunden ist.

Das zu vermessende Display 1 kann beispielsweise als Flüssigkeitskristallanzeige (LCD liquid crystal display) oder als organisches Leuchtdisplay (OLED organic light emitting diode) ausgebildet sein.

Der Computer 2 ist dafür eingerichtet, Bilder oder Grafiken auf dem Display 1 auszugeben. An Stelle des Computers 2 kann zur Ausgabe von Bildern auf dem Display 1 auch ein nicht näher dargestellter Testbildgenerator verwendet werden.

Vorliegend dargestellt ist die Ausgabe eines Einbrennbildes EB auf dem Display 1. Das Einbrennbild EB ist als über den gesamten Bildbereich verteiltes Schachbrettmuster mit quadratischen Feldern ausgebildet. Die quadratischen Felder weisen jeweils eine näherungsweise homogene Leuchtdichte auf, wobei sich angrenzende Felder sich in der Leuchtdichte unterscheiden. Vorzugsweise ist das Schachbrettmuster aus Feldern mit maximalem Kontrastunterschied aufgebaut.

Die Verbindung zwischen dem Computer 2 oder dem nicht näher dargestellten Testbildgenerator und dem Display 1 kann beispielsweise als VGA (Video Graphics Array) - Verbindung, als HDMI (High Definition Multimedia Interface) - Verbindung, als Displayport - Verbindung oder als DVI (Digital Visual Interface) - Verbindung ausgebildet sein. Auch generische Bustypen, deren Einsatz nicht auf die Übertragung von Bildern oder Grafiken beschränkt ist, können zur Verbindung des Computers 2 oder eines Testbildgenerators mit dem Display 1 verwendet werden. Beispielsweise kann ein Controller Area Network (CAN) Bus zur Verbindung verwendet werden.

Die Kamera 3 ist zur Aufnahme eines in Figur 1 nicht näher dargestellten Kamerabildes KB eingerichtet, welches das von dem Display 1 dargestellte Einbrennbild EB erfasst. Die Kamera 3 ist so eingerichtet, dass die von dem Display 1 emittierte Leuchtdichte pixelweise als Grauwert oder als Farbwert erfasst wird. Insbesondere ist die optische Achse der Kamera 3 senkrecht zum Display 1 ausgerichtet. Zudem ist die Kamera 3 dafür eingerichtet, für eine Mehrzahl von Bildpixeln fotometrische oder farbmetrische Pixelwerte bereitzustellen.

Der Computer 2 ist dafür eingerichtet, ein von der Kamera 3 aufgenommenes Kamerabild KB zu empfangen und auszuwerten.

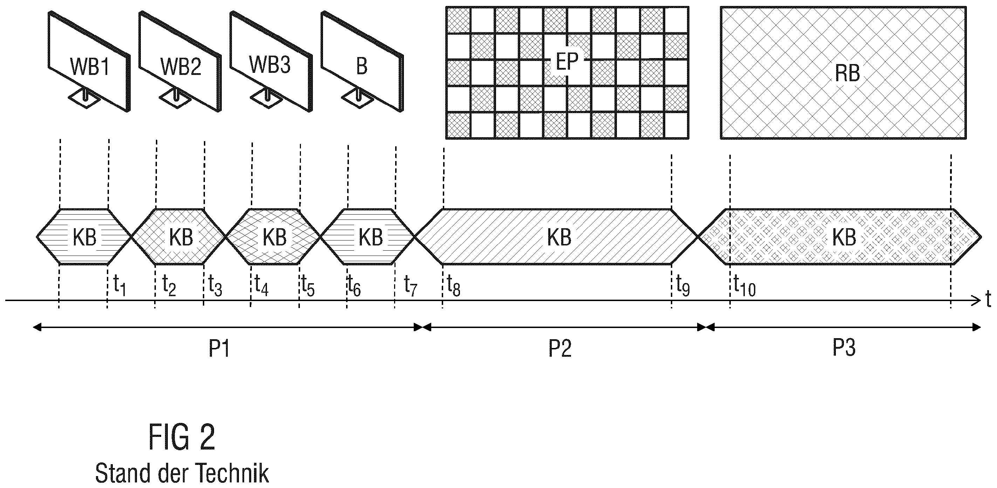

Figur 2 zeigt schematisch den Ablauf von Bildern, welche nach dem Stand der Technik bei der Vermessung des Einbrennverhaltens auf dem Display 1 dargestellt werden. Der Ablauf ist in drei Phasen P1, P2, P3 unterteilt.

In einer ersten Phase P1 wird das Display 1 vom Computer 2 mit einer rollenden Abfolge von Aufwärmbildern WB1 bis WB3 angesteuert. Die Aufwärmbilder WB1 bis WB3 weisen eine näherungsweise homogene Grauwertverteilung mit voneinander unterschiedlichen Grauwerten auf. Die Aufwärmbilder WB1 bis WB3 sind so ausgebildet, dass das Display 1 einen stationären Betriebszustand erreicht und das keine Einbrenneffekte an dem Display 1 ausgelöst werden. Die Abfolge der Aufwärmbilder WB1 bis WB3 ist in Figur 2 nur einmalig dargestellt, kann jedoch zyklisch wiederholt werden, wenn dies zum Erreichen eines stationären Betriebszustands erforderlich ist.

Am Ende der ersten Phase P1 wird das Display 1 mit einem Referenzbild B0 angesteuert, das einen homogenen Referenzgrauwert aufweist.

In einer zweiten Phase P2, die sich an die erste Phase P1 anschließt, wird das Display 1 mit dem Einbrennbild EB angesteuert, das bereits anhand von Figur 1 beschrieben wurde.

In einer dritten Phase P3, die sich an die zweite Phase P2 anschließt, wird das Display 1 mit einem Relaxationsbild RB angesteuert. Vorzugsweise ist das Relaxationsbild RB gleich dem Referenzbild B0.

Zu jedem von dem Display 1 dargestellten Displaybild DB wird mindestens ein Kamerabild KB(DB) durch die Kamera 3 aufgenommen. Ein Einbrenneffekt, insbesondere eine Relaxationszeitkonstante $\tau$ kann aus dem Vergleich des dem Referenzbild B0 zugeordneten Kamerabildes KB(B0) mit dem dem Relaxationsbild RB zugeordneten Kamerabild KB(RB) bestimmt werden.

Für eine genaue Bestimmung des Einbrenneffekts ist es vorteilhaft, wenn der Zeitabstand zwischen der Darstellung des Relaxationsbildes RB auf dem Display 1 und der Aufnahme des zugeordneten Kamerabildes KB(RB) möglichst genau bekannt ist.

Die Ansteuerung des Displays 1 durch den Computer 2, das heißt: Die Ausgabe eines jeweils anderen Bildes über die Verbindung zwischen dem Computer 2 und dem Display 1, erfolgt zu Ansteuerzeitpunkten $t_1$, $t_3$, ... $t_9$. Aufgrund der Signalübertragung vom Computer 2 zum Display 1, aufgrund der Trägheit des Displays 1 sowie aufgrund der Belichtungszeit der Kamera 3, welche üblicherweise einige Hundertstel- bis Zehntelsekunden beträgt, und dem gegenüber der Taktung der Displaybilder DB versetzten Takt zum Auslesen der Kamerabilder KB erscheinen die vom Computer 2 bereitgestellten Displaybilder DB in der Kamera 3 verzögert zu Umschaltzeitpunkten $t_2$, $t_4$, ... $t_{10}$ als Kamerabilder KB.

Mit aus dem Stand der Technik bekannten Verfahren kann die Latenz

$$\Delta t_{i,i+1} = t_{i+1} - t_i, \qquad i = 1, 3, 5, 7, 9$$

zwischen dem Umschalten des Displaybildes DB durch den Computer 2 und dem Zeitpunkt der Aufnahme des dem neuen Displaybild DB zugeordneten Kamerabildes KB daher nicht genau ermittelt werden. Dies beeinträchtigt auch die Genauigkeit bei der Ermittlung des Einbrenneffekts.

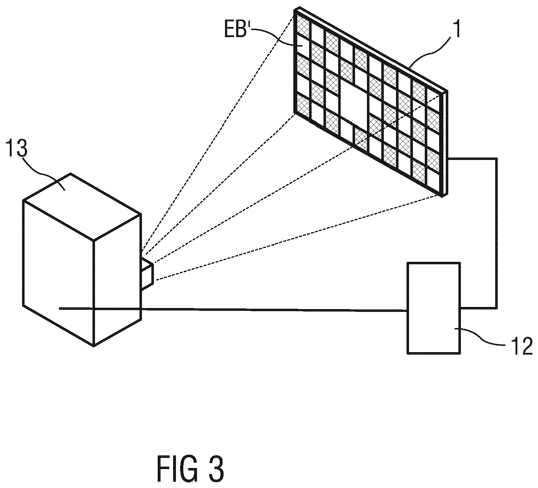

Die vorliegende Erfindung hat diesen Nachteil erkannt und überwunden, wie anhand des in Figur 3 dargestellten, gegenüber Figur 1 veränderten Messaufbaus nachfolgend erklärt wird.

Der Messaufbau weist eine modifizierte Kamera 13 und einen modifizierten Computer 12 auf. Der Computer 12 ist dafür eingerichtet, ein modifiziertes Einbrennbild EB' auf dem Display 1 darzustellen. Das modifizierte Einbrennbild EB' weist einen Triggerbildbereich TB mit einer homogenen Grauwertverteilung auf. Vorzugsweise überdeckt der Triggerbildbereich TB eine Mehrzahl von Feldern des Schachbrettmusters und weist einen Grauwert auf, der sich vom mittleren Grauwert des Einbrennbildes EB' sowie auch vom mittleren Grauwert des Relaxationsbildes RB möglichst stark unterscheidet. Beispielsweise kann der Triggerbildbereich TB den maximalen (hellsten) mit dem Display 1 darstellbaren Grauwert aufweisen.

Die modifizierte Kamera 13 ist dafür eingerichtet, einen vorgegebenen Teilbereich eines Kamerabildes KB einzulesen und/oder auszuwerten. Insbesondere ist die modifizierte Kamera 13 dafür eingerichtet, diesen Teilbereich mit einer höheren Geschwindigkeit und mit einer höheren Frequenz einzulesen als das vollständige Kamerabild KB. Änderungen in dem von dem vorgegebenen Teilbereich erfassten Kamerabild KB können daher besonders schnell detektiert werden.

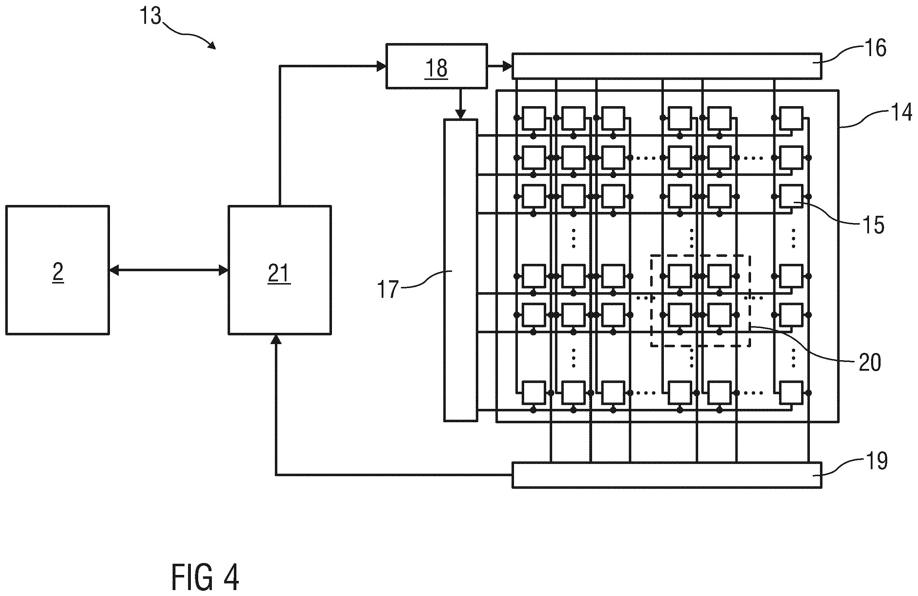

In einer in Figur 4 dargestellten Ausführungsform ist die Kamera 13 als CMOS (complementory metal-oxide-semiconductor) Kamera ausgebildet und weist ein Sensorfeld 14 mit einer Mehrzahl von matrixartig angeordneten lichtempfindlichen Sensorpixeln 15 auf. Die digitalisierten Messwerte des Sensorfelds 14 bilden das Kamerabild KB.

Mittels eines Spaltenadressdekoders 16 und eines Zeilenadressdekoders 17 wird ein Sensorpixel 15 zur Ausgabe ausgewählt, dessen Adresse mit der von einem Adressgenerator 18 vorgegebenen Adresse übereinstimmt. Der ausgewählte Sensorpixel 15 wird in einem Ausleseregister 19 als Digitalwert bereitgestellt. In gleicher Weise kann ein Bereich von Sensorpixeln 15 einer Zeile des Sensorfeldes 14 als Mehrzahl von Digitalwerten in dem Ausleseregister 19 bereitgestellt werden.

Dadurch ist es möglich, alle Sensorpixel 15, die in einem quadratischen oder rechteckigen Triggerteilfeld 20 des Sensorfelds 14 liegen, besonders schnell auszulesen, insbesondere sehr viel schneller und in sehr viel kürzeren Zeitabständen als die Gesamtheit der Sensorpixel 15 des Sensorfeldes 14.

Die Kamera 13 weist ferner eine Kamerasteuerung 21 auf, die mit dem Adressgenerator 18 und mit dem Ausleseregister 19 verbunden ist und die eine Schnittstelle zum Austausch von Daten mit dem Computer 2 aufweist.

Im Folgenden wird das erfindungsgemäße Betreiben der in Figur 3 dargestellten Kamera 13 beschrieben.

Ein Kamerabild KB wird als Gesamtheit aller digitalisierten Pixelwerte der Sensorpixel 15 des Sensorfeldes 14 an den Computer 2 übertragen. Im Computer 2 wird ein Teilbereich von Pixeln des Kamerabildes KB identifiziert, der den Triggerbildbereich TB des auf dem Display 1 dargestellten Einbrennbildes EB' überdeckt. Vorzugsweise wird ein rechteckiger oder quadratischer Teilbereich des Kamerabildes KB ermittelt, der eine möglichst große Fläche des Triggerbildbereichs TB abdeckt.

Dieser Teilbereich kann durch automatische Bildverarbeitung ermittelt werden. Die Ermittlung des Teilbereichs in dem Kamerabild KB kann auch durch manuelle Markierung erfolgen, indem das Kamerabild KB auf einer nicht näher dargestellten Anzeigevorrichtung dargestellt wird und, beispielsweise mittels eines Zeigegeräts, ein in den Triggerbildbereich TB eingeschriebenes Rechteck oder Quadrat ausgewählt wird.

Aus der Angabe des Teilbereichs im Kamerabild KB kann, durch Übertragung der Koordinaten von Pixeln des Kamerabildes KB auf Zeilenadressen und Spaltenadressen von Sensorpixeln 15 des Sensorfeldes 14, der Adressbereich des Triggerteilfelds 20 bestimmt und an die Kamerasteuerung 21 übermittelt werden. Beispielsweise können die Indizes der ersten und letzten Spalte und der ersten und letzten Zeile des Sensorfeldes 14 übermittelt werden, welche das Triggerteilfeld 20 begrenzen.

Die Kamerasteuerung 21 ist so eingerichtet und programmiert, dass die digitalisierten Pixelwerte des Triggerteilfelds 20 fortlaufend ausgelesen werden und daraus jeweils ein Triggerkennwert T aus den Pixelwerten des Triggerteilfelds 20 bestimmt wird. Beispielsweise kann als Triggerkennwert T die Summe oder der Mittelwert der Pixelwerte des Triggerteilfelds 20 bestimmt werden.

Aufgrund des im Vergleich zum Sensorfeld 14 sehr kleinen Triggerteilfelds 20 kann der Triggerkennwert T in sehr kurzen Zeitabständen ermittelt werden.

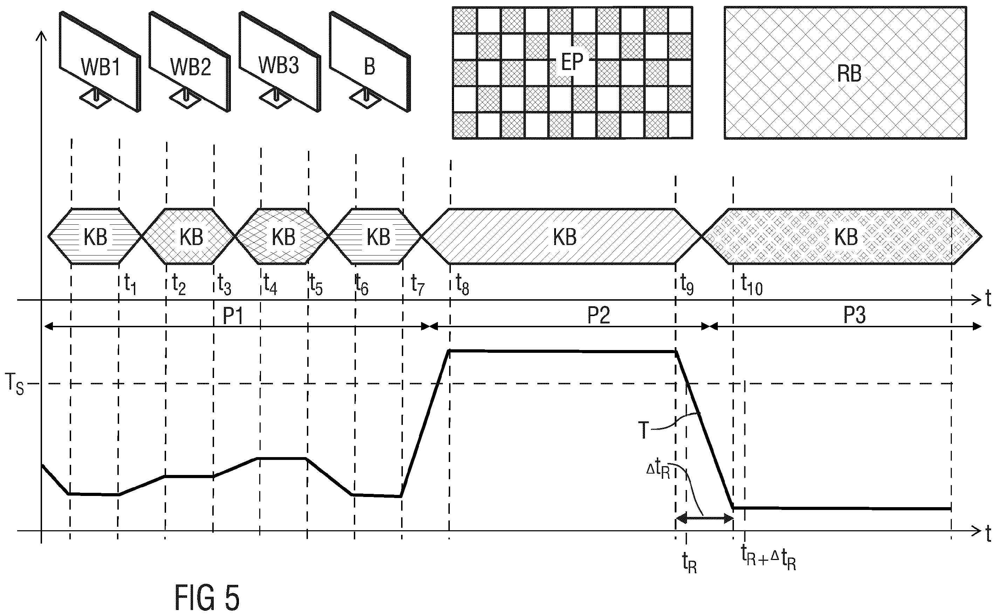

Figur 5 zeigt den Verlauf des so ermittelten Triggerkennwerts T über der Zeitachse t. Da das Triggerteilfeld 20 auf den Triggerbildbereich TB des auf dem Display 1 dargestellten Displaybildes DB abgestimmt ist, weist der Zeitverlauf des Triggerkennwerts T dann besonders hohe Werte auf, wenn auf dem Display 1 das Einbrennbild EB' mit dem überlagerten Triggerbildbereich TB mit einem besonders hohen (hellen) Grauwert dargestellt ist.

Dadurch ist es möglich, den Umschaltzeitpunkt $t_{10}$, zu dem das Display 1 zwischen der Darstellung des Einbrennbildes EB' und der Darstellung des Relaxationsbildes RB umschaltet, genauer zu bestimmen. Beispielsweise kann anhand des in dem Triggerbildbereich TB dargestellten besonders hohen (hellen) Grauwerts und anhand der Ausdehnung des Triggerbildbereichs TB sowie anhand der Belichtungszeit, während der der Triggerbildbereich TB jeweils belichtet wird, ein Triggerintegralschwellwert $T_S$ bestimmt werden. Überschreitet der durch die Kamerasteuerung 21 ermittelte Triggerkennwert T den Triggerintegralschwellwert $T_S$, so zeigt diese Überschreitung an, dass von der Kamera 13 das Einbrennbild EB' aufgenommen wurde.

Entsprechend zeigt die nachfolgend erste Unterschreitung des Triggerintegralschwellwerts $T_S$ zum Zeitpunkt $t_R$ an, dass von dem Display 1 das Relaxationsbild RB dargestellt und dieses von der Kamera 13 aufgenommen wird. Dieser Zeitpunkt kann als Relaxationsbeginn $t_R$ erfasst werden, zu dem die Relaxation des Displays 1 beginnt und auf den die zeitlich abnehmende Abweichung des während der dritten Phase P3 (Relaxationsphase) aufgenommenen Kamerabildes KB(RB) gegenüber dem am Ende der ersten Phase P1 (Aufwärmphase) aufgenommenen Kamerabildes KB(B0) zu beziehen ist.

Die Aufnahme des Kamerabildes KB(RB), welches ein nach dem Relaxationsbeginn $t_R$ von dem Display 1 dargestelltes Relaxationsbild RB erfasst, wird durch ein Triggersignal ausgelöst. Das Triggersignal kann unmittelbar zu dem festgestellten Relaxationsbeginn $t_R$ generiert werden. Bevorzugt wird das Triggersignal nach einer vorbestimmten Verzögerung oder Wartezeit $\Delta t_R$, das heißt: zum Zeitpunkt $t_R + \Delta t_R$, generiert, wobei diese Verzögerung, wie nachfolgend noch genauer erklärt wird, abhängig von dem Umschaltzeitintervall $[t_9, t_{10}]$ gewählt wird, das für die Anzeigevorrichtung bekannt ist oder ermittelt wird.

Ein Vorteil des erfindungsgemäßen Verfahrens besteht somit darin, dass die Genauigkeit, mit der der Beginn der Relaxation des Displays 1 bestimmt werden kann, im Wesentlichen nur noch begrenzt wird von der Genauigkeit, mit der der Triggerintegralschwellwert $T_S$ ermittelt wird, sowie vom Zeitabstand, in dem durch die Kamera 13 jeweils alle Sensorpixel 15 innerhalb des Triggerteilfelds 20 ausgelesen und aufsummiert werden können.

Gegenüber dem Stand der Technik spielen Latenzen und Jitter bei der Übertragung eines Displaybildes DB vom Computer 2 an das Display 1 keine Rolle. Auch die Trägheit des Displays 1 beeinflusst die Genauigkeit bei der Bestimmung des Relaxationsbeginns $t_R$ nicht oder nur unwesentlich.

Durch die genauere Bestimmung des Relaxationbeginns $t_R$ ist auch eine genauere Bestimmung des Einbrenneffekts möglich als mit Verfahren aus dem Stand der Technik. Beispielsweise kann eine Relaxationszeitkonstante $\tau$ zuverlässiger und genauer bestimmt werden.

Bei einer Ausführungsform kann die Ermittlung des Triggerkennwertes T nur in einem Zeitintervall um den Ansteuerzeitpunkt $t_9$ ausgeführt werden, wenn vom Computer 2 an das Display 1 nach dem Einbrennbild EB' das Relaxationsbild RB übertragen wird. Dieses Zeitintervall kann grob, beispielsweise auf einige Zehntelsekunden, eingegrenzt werden. Beispielsweise kann der Computer 2 so programmiert sein, dass unmittelbar vor dem Wechsel des Displaybildes DB vom Einbrennbild EB' zum Relaxationsbild RB ein Signal an die Kamerasteuerung 21 übermittelt wird, welches die Ermittlung des Triggerkennwerts T für eine vorbestimmte Zeitdauer, beispielsweise von 500 Millisekunden, auslöst.

Die Kamerasteuerung 21 kann zudem so konfiguriert sein, dass die Belichtung des auf das Relaxationsbild RB bezogenen Kamerabildes KB(RB) nach Ablauf einer vorbestimmten Wartezeit $\Delta t_R$ ab dem Relaxationsbeginn $t_R$ beginnt. Die vorbestimmte Wartezeit $\Delta t_R$ kann beispielsweise durch den Nutzer am Computer 2 eingegeben werden und von dem Computer 2 an die Kamerasteuerung 21 übertragen werden.

Es ist möglich, die vorbestimmte Wartezeit $\Delta t_R$ so einzustellen, dass der Umschaltvorgang des Displays 1 von der Darstellung des Einbrennbildes EB' auf die Darstellung des Relaxationsbildes RB sicher abgeschlossen ist, wenn das auf das Relaxationsbild RB bezogene Kamerabild KB(RB) belichtet wird. Vorzugsweise wird die Wartezeit $\Delta t_R$ gleich oder geringfügig größer eingestellt als das Umschaltzeitintervall $[t_9, t_{10}]$. Das $[t_9, t_{10}]$ gibt den Zeitbereich an, in dem die Bildpixel des angezeigten Bildes sicher vom Einbrennbild EB auf das Relaxationsbild RB umgeschaltet werden.

Dadurch wird vermieden, dass ein Kamerabild KB zu einem Zeitpunkt aufgenommen wird, zu dem von der Anzeigevorrichtung 1 teilweise, insbesondere in Bildbereichen außerhalb des Triggerbildbereichs TB, noch das Einbrennbild EB angezeigt wird, und dadurch die Wirkung des Einbrennens überschätzt wird. Dadurch wird die Zuverlässigkeit in der Bewertung des Relaxationsverhaltens des Display 1 verbessert.

Es ist auch möglich, die vorbestimmte Wartezeit $\Delta t_R$ nach Kriterien einzustellen, die spezifische Anforderungen bei der Verwendung des Displays 1 erfassen und/oder die durch Prüfnormen vorgegeben sein können.

In einer Ausführungsform kann das Einbrennverhalten des Displays 1, beispielsweise die Relaxationszeitkonstante $\tau$, anhand eines Teilbereichs des korrespondierend zum Relaxationsbild RB aufgenommenen Kamerabildes KB(RB) ermittelt werden. Beispielsweise kann das Einbrennverhalten durch Auswertung nur derjenigen Bildpixel des Kamerabildes KB(RB) ermittelt werden, die von den Sensorpixeln 15 innerhalb des Triggerteilfeldes 20 bereitgestellt werden, wobei das Einbrennbild EB' und das Relaxationsbild RB derart gewählt sind, dass sich die Summe oder der Mittelwert der dem Triggerbildbereich TB jeweils zugeordneten Bildpixel zwischen dem Einbrennbild EB' und dem Relaxationsbild RB voneinander unterscheiden.

Es ist aber auch möglich, dass zur Bestimmung des Einbrennverhaltens ein Sensorpixel 15 oder mehrere Sensorpixel 15 des vom Relaxationsbild aufgenommenen Kamerabildes KB(RB) ausgelesen und mit dem Kamerabild KB(EB) des Einbrennbildes EB verglichen werden, welche nicht oder nur zu einem Teil im Triggerteilfeld 20 liegen.

Beispielsweise kann das Einbrennbild EB' ein Schachbrettmuster mit dunklen (schwarzen) und hellen (weißen) Feldern aufweisen, wobei dem Triggerbildbereich TB ein oder mehrere helle (weiße) Felder des Schachbrettmusters zugeordnet sind. Das Referenzbild B0 ist hierbei homogen mit einem mittleren (grauen) Grauwert gewählt.

Das Einbrennverhalten wird dann durch Auswertung der im Triggerteilfeld 20 oder einem anderen Teilfeld des Sensorfeldes 14 angeordneten Sensorpixel 15 bestimmt, auf die während des Einbrennens (zweite Phase P2) das oder die ausgewählten weißen Felder abgebildet werden und während der Relaxation (dritte Phase P3) dann die durch das Einbrennen gestörten mittleren Grauwerte. Es ist auch möglich, an Stelle der ausgewählten hellen (weißen) Felder des Schachbrettmusters dem Triggerbildbereich TB ausgewählte dunkle (schwarze) Felder des Schachbrettmusters zuzuordnen.

Ein Vorteil dieser Ausführungsform besteht darin, dass durch eine verringerte Pixelanzahl die Bestimmung, ob der über dem Triggerbildbereich TB ermittelt Triggerkennwert T den Triggerschwellwert $T_S$ überstreicht (das heißt: überschreitet oder unterschreitet) schneller möglich ist. Dadurch wird eine höhere zeitliche Auflösung bei der Bestimmung des Zeitpunktes erzielt, zu dem der Triggerkennwert T den Triggerschwellwert $T_S$ überstreicht. Es kann somit der Relaxationsbeginn $t_R$ genauer ermittelt und das Einbrennverhalten des Displays 1 genauer bestimmt werden.

Darüber hinaus wird durch das Auslesen nur eines Teilfeldes des Sensorfeldes 14 während der Relaxation (dritte Phase P3) eine Auslesetaktrate erzielt, die höher als die für das vollständige Auslesen aller Sensorpixel 15 der Kamera 13 vorgesehene Kamerataktrate ist. Dadurch kann der zeitliche Verlauf der potenziell durch das Einbrennen gestörten, von dem Display 1 dargestellten Grauwerte während der Relaxation mit einer höheren zeitlichen Auflösung erfasst und daraus das Einbrennverhalten des Displays 1 genauer bestimmt werden.

Dabei ist es möglich, aber nicht erforderlich, dass das während der Relaxation ausgelesene Teilfeld des Sensorfeldes 14 identisch oder überlappend zum Triggerteilfeld 20 gewählt wird, welches zur fortlaufenden Bestimmung des Triggerkennwerts T und zur Ermittlung des Relaxationsbeginns $t_R$ ausgewertet wird. Es ist ebenfalls möglich, aber nicht erforderlich, dass das während der Relaxation ausgelesene Teilfeld zusammenhängend gewählt ist. Das Teilfeld wird so gewählt, dass es mit einer gegenüber der Kameratktrate erhöhten Auslesetaktrate ausgelesen werden kann. Daraus resultiert der Vorteil einer höheren zeitlichen Auflösung bei der Bestimmung des Relaxationsverhaltens, und damit bei der Bewertung des Einbrennverhaltens für das Display 1.

In einer alternativen Ausführungsform kann die Auswertung der Bildpixel des Kamerabildes KB auch auf dem Computer 2 erfolgen, wobei die Kamerasteuerung 21 so konfiguriert ist, dass das Kamerabild KB oder der dem Triggerbildbereich TB entsprechende Teil des Kamerabildes KB an den Computer 2 übermittelt wird. Diese Ausführungsform hat den Vorteil, dass die Auswertung des Kamerabildes KB unabhängig von der konkret eingesetzten Kamera 13 implementiert sein kann und dass somit flexibel verschiedene Typen von Kameras 13 eingesetzt werden können.

Demgegenüber hat die Ausführungsform, bei der die Sensorwerte des Sensorfeldes 14 und/oder des Triggerteilfeldes 20 durch die Kamerasteuerung 21 erfolgt, den Vorteil, dass weniger Daten zwischen der Kamera 13 und dem Computer 2 übertragen werden müssen. Dadurch sind eine geringere Latenz und ein geringerer Jitter zwischen dem Ansteuerzeitpunkt $t_9$ der Umschaltung auf das Relaxationsbild RB und dem ermittelten Relaxationsbeginn $t_R$ möglich.

BEZUGSZEICHENLISTE

| | |
|---|---|
| 1 | Display, Anzeigevorrichtung |
| 2, 12 | Computer, Steuereinheit |
| 3, 13 | Kamera |
| 14 | Sensorfeld |
| 15 | Sensorpixel |
| 16 | Spaltenadressdekoder |
| 17 | Zeilenadressdekoder |
| 18 | Adressgenerator |
| 19 | Ausleseregister |
| 20 | Triggerteilfeld |
| 21 | Kamerasteuerung |

| | |
|---|---|
| B0 | Referenzbild |
| P1 | erste Phase, Aufwärmphase |
| P2 | zweite Phase, Einbrennphase |
| P3 | dritte Phase, |
| DB | Displaybild, Anzeigebild |
| EB, EB' | Einbrennbild |
| KB | Kamerabild |
| RB | Relaxationsbild |
| TB | Triggerbildbereich |
| T | Triggerkennwert |
| t | Zeitachse |
| $t_1, t_3, t_5, t_7, t_9$ | Ansteuerzeitpunkt |
| $t_2, t_4, t_6, t_8, t_{10}$ | Umschaltzeitpunkt |
| $t_R$ | Relaxationsbeginn, Zeitpunkt |
| $\Delta t_R$ | Wartezeit |
| WB1, WB2, WB3 | erstes bis drittes Aufwärmbild |

**Patentansprüche**

1. Verfahren zur Bestimmung eines Relaxationsbeginns ($t_R$) beim Umschalten einer pixelweise ansteuerbaren optischen Anzeigevorrichtung (1) von einem Einbrennbild (EB') auf ein Relaxationsbild (RB), wobei

- in dem Einbrennbild (EB') ein Triggerbildbereich (TB) umfassend mindestens ein Bildpixel derart mit Pixelwerten belegt wird, dass ein über dem mindestens einen Pixelwert im Triggerbildbereich (TB) des Einbrennbildes (EB')gebildeter erster Parameter sich von einem in gleicher Weise über dem mindestens einen Pixelwert im Triggerbildbereich (TB) des Relaxationsbildes (RB)gebildeten zweiten Parameter unterscheidet,

- mittels einer Kamera (3, 13) umfassend ein Sensorfeld (14) von Sensorpixeln (15) die örtliche Verteilung eines Grauwertes korrespondierend zur örtlichen Verteilung einer photometrischen Kenngröße über der Anzeigevorrichtung (1) zeitlich fortlaufend erfasst wird, wobei die Kamera (3, 13) zum Auslesen der Gesamtheit aller Sensorpixel (15) mit einer Kameratktrate eingerichtet ist und Teilbereiche des Sensorfelds (14) mit einer höheren Taktrate auslesen kann, wobei

o ein Triggerteilfeld (20) umfassend mindestens einen Sensorpixel (15) überlappend zu dem Triggerbildbereich (TB) eines auf der Anzeigevorrichtung (1) dargestellten Anzeigebildes (DB) festgelegt wird und

o mit einer Triggertaktrate zeitlich fortlaufend ein Triggerkennwert (T) aus den Pixelwerten des mindestens einen Sensorpixels (15) in dem Triggerteilfeld (20) bestimmt wird,

o wobei das Triggerteilfeld (20) als Teilbereich des Sensorfeldes (15) festgelegt und mit der Triggertaktrate ausgelesen wird, und

- ein Triggerschwellwert ($T_S$) bestimmt wird, der zwischen dem Triggerkennwert (T), der sich für die Aufnahme des Einbrennbildes (EB') ergibt, und dem Triggerkennwert (T), der sich für die Aufnahme des Relaxationsbildes (RB) ergibt, liegt und

- der Relaxationsbeginn ($t_R$) als der Zeitpunkt ermittelt wird, zu dem der fortlaufend ermittelte Triggerkennwert ($T$) den Triggerschwellwert ($T_S$) überstreicht, wobei die Triggertaktrate höher als die für das Auslesen der Gesamtheit der Sensorpixel (15) des Sensorfelds (14) vorgesehene Kamerataktrate gewählt wird.

2. Verfahren nach Anspruch 1, wobei der Triggerkennwert (T) nur in einem Zeitbereich von vorbestimmter Dauer erfasst wird, der den Zeitpunkt umfasst, zu dem die Ansteuerung der Anzeigevorrichtung (1) von dem Einbrennbild (EB') auf das Relaxationsbild (RB) umgeschaltet wird.

3. Verfahren nach Anspruch 2, wobei aus einer Mehrzahl von aufeinanderfolgend ermittelter Triggerkennwerte (T) ein gleitender Mittelwert bestimmt und mit dem Triggerschwellwert ($T_S$) verglichen wird.

4. Verfahren nach einem der vorhergehenden Ansprüche, wobei die Pixelwerte im Triggerbildbereich (TB) derart gewählt sind, dass ein erster Mittelwert von Pixelwerten im Triggerbildbereich (TB) des Einbrennbildes (EB') höher ist als ein zweiter Mittelwert von Pixelwerten im Triggerbildbereich (TB) des Relaxationsbildes (RB), vorzugsweise so gewählt sind, dass mindestens in einem Teilbereich des Triggerbildbereichs (TB) des Einbrennbildes (EB') die mit der Anzeigevorrichtung (1) maximal erzielbare Leuchtdichte erzielt wird.

5. Verfahren zur Bestimmung des Einbrennverhaltens einer pixelweise ansteuerbaren optischen Anzeigevorrichtung (1), wobei

- die Anzeigevorrichtung (1), wenn sie keinem Einbrennvorgang ausgesetzt war, zur Darstellung eines Referenzbildes (B0) angesteuert wird, wobei
- mittels einer Kamera (3, 13) ein erstes Kamerabild (KB(B0)) aufgenommen wird, das die örtliche Verteilung eines Grauwertes korrespondierend zur örtlichen Verteilung einer fotometrischen Kenngröße über der Anzeigevorrichtung (1) erfasst, während diese zur Darstellung des Referenzbildes (B0) angesteuert wird,
- die Anzeigevorrichtung (1) für eine vorbestimmte Einbrenndauer zur Darstellung eines Einbrennbildes (EB') angesteuert wird,
- die Anzeigevorrichtung (1) zur Darstellung eines Relaxationsbildes (RB) angesteuert wird, wobei

o mittels der Kamera (3, 13) mindestens ein weiteres Kamerabild (KB(RB)) aufgenommen wird, das die örtliche Verteilung eines Grauwertes korrespondierend zur örtlichen Verteilung einer photometrischen Kenngröße über der Anzeigevorrichtung (1) erfasst, während diese zur Darstellung des Relaxationsbildes (RB) angesteuert wird und

o ein Relaxationsbeginn ($t_R$) mittels der Kamera (3, 13) nach einem Verfahren der vorhergehenden Ansprüche ermittelt wird und

- aus dem ersten Kamerabild (KB(B0)), dem mindestens einen weiteren Kamerabild (KB(RB)) sowie dem Relaxationsbeginn ($t_R$) das Einbrennverhalten für die Anzeigevorrichtung (1) ermittelt wird.

6. Verfahren nach Anspruch 5, wobei von dem mindestens einen weiteren Kamerabild (KB(RB)), das die örtliche Verteilung eines Grauwertes korrespondierend zur örtlichen Verteilung einer photometrischen Kenngröße über der Anzeigevorrichtung (1) erfasst, während diese zur Darstellung des Relaxationsbildes (RB) angesteuert wird, ein Teilfeld des Sensorfeldes (14) mit einer Auslesetaktrate ausgelesen wird, die höher als die für das vollständige Auslesen des Sensorfelds (14) vorgesehene Kamerataktrate ist.

7. Verfahren nach Anspruch 6, wobei das mit der Auslesetaktrate ausgelesene Teilfeld das Triggerteilfeld (20) mindestens teilweise überlappt.

8. Verfahren nach einem der Ansprüche 5 bis 7, wobei die Kamera (3, 13) als Leuchtdichtemesskamera (13) ausgebildet ist.

9. Verfahren nach einem der Ansprüche 5 bis 8, wobei das mindestens eine weitere Kamerabild (KB(RB)) in einem vorbestimmten zeitlichen Versatz zum ermittelten Relaxationsbeginn ($t_R$) aufgenommen wird.

10. Vorrichtung umfassend eine Steuereinheit (2, 12) und eine Kamera (3, 13), wobei die Steuereinheit (2, 12) zur Ansteuerung einer pixelweise ansteuerbaren optischen Anzeigevorrichtung (1) eingerichtet ist, wobei die Steuereinheit (2, 12) und die Kamera (3, 13) zur Durchführung eines Verfahrens nach einem der Ansprüche 4 bis 6 eingerichtet sind und wobei die Kamera (3, 13) als Complementary Metal-Oxide Semiconductor (CMOS) Kamera oder als Charged Coupled Device (CCD) Kamera ausgebildet ist.

11. Vorrichtung nach Anspruch 10, wobei die Kamera (3, 13) zur fortlaufenden Bestimmung des Triggerkennwertes (T) aus dem mindestens einen Pixelwert der Sensorpixel (15) in dem Triggerteilfeld (20) und zum Vergleich des Triggerkennwertes (T) mit dem Triggerschwellwert ($T_S$) eingerichtet ist.

12. Anwendung eines Verfahrens nach einem der Ansprüche 5 bis 9 zur Bestimmung des Einbrennverhaltens eines Displays (1), das für den Einsatz in einem Fahrzeug vorgesehen ist.

## Claims

1. Method for determining a start of relaxation ($t_R$) when switching a pixel-by-pixel controllable optical display device (1) from a burn-in image (EB') to a relaxation image (RB), wherein

   - in the burn-in image (EB') a trigger image area (TB) comprising at least one image pixel is allocated pixel values such that a first parameter formed over the at least one pixel value in the trigger image area (TB) of the burn-in image (EB') differs from a second parameter formed in the same way over the at least one pixel value in the trigger image area (TB) of the relaxation image (RB),
   - by means of a camera (3, 13) comprising a sensor field (14) of sensor pixels (15), the spatial distribution of a greyscale value corresponding to the spatial distribution of a photometric characteristic variable over the display device (1) is recorded continuously over time, wherein the camera (3, 13) is configured for reading out the totality of all sensor pixels (15) with a camera clock rate and subareas of the sensor field (14) can be read out with a higher clock rate, wherein

      o a trigger subfield (20) comprising at least one sensor pixel (15) is defined overlapping with respect to the trigger image area (TB) of a display image (DB) presented on the display device (1), and
      o with a trigger clock rate, a trigger characteristic value (T) is determined continuously over time from the pixel values of the at least one sensor pixel (15) in the trigger subfield (20),
      o wherein the trigger subfield (20) is defined as a subarea of the sensor field (15) and is read out with the trigger clock rate, and

   - a trigger threshold value ($T_S$) is determined, which lies between the trigger characteristic value ($T$) resulting for the recording of the burn-in image (EB') and the trigger characteristic value ($T$) resulting for the recording of the relaxation image (RB), and
   - the start of relaxation ($t_R$) is ascertained as the point in time at which the continuously ascertained trigger characteristic value ($T$) crosses the trigger threshold value ($T_S$), wherein the trigger clock rate is chosen to be higher than the camera clock rate provided for reading out the totality of the sensor pixels (15) of the sensor field (14).

2. Method according to Claim 1, wherein the trigger characteristic value (T) is only recorded in a time period of predetermined duration, which comprises the point in time at which the control of the display device (1) is switched from the burn-in image (EB') to the relaxation image (RB).

3. Method according to Claim 2, wherein a moving average value is determined from a plurality of successively ascertained trigger characteristic values ($T$) and is compared with the trigger threshold value ($Ts$).

4. Method according to any of the preceding claims, wherein the pixel values in the trigger image area (TB) are chosen such that a first average value of pixel values in the trigger image area (TB) of the burn-in image (EB') is higher than a second average value of pixel values in the trigger image area (TB) of the relaxation image (RB), and are preferably chosen such that the maximum luminance achievable with the display device (1) is achieved at least in a subarea of the trigger image area (TB) of the burn-in image (EB').

5. Method for determining the burn-in behaviour of a pixel-by-pixel controllable optical display device (1), wherein

   - the display device (1), if it has not been subjected to a burn-in process, is controlled for presenting a reference image (B0), wherein
   - by means of a camera (3, 13), a first camera image (KB(B0)) is recorded, which records the spatial distribution of a greyscale value corresponding to the spatial distribution of a photometric characteristic variable over the display device (1) while the latter is controlled for presenting the reference image (B0),
   - the display device (1) is controlled for presenting a burn-in image (EB') for a predetermined burn-in period,
   - the display device (1) is controlled for presenting a relaxation image (RB), wherein o by means of the camera (3, 13), at least one further camera image (KB(RB)) is recorded, which records the spatial distribution of a greyscale value corresponding to the spatial distribution of a photometric characteristic variable over the display device (1) while the latter is controlled for presenting the relaxation image (RB), and o a start of relaxation ($t_R$) is ascertained by means of the camera (3, 13) according to a method of the preceding claims, and

- the burn-in behaviour for the display device (1) is ascertained from the first camera image (KB(B0)), the at least one further camera image (KB(RB)) and the start of relaxation ($t_R$).

6. Method according to Claim 5, wherein from the at least one further camera image (KB(RB)), which records the spatial distribution of a greyscale value corresponding to the spatial distribution of a photometric characteristic variable over the display device (1) while the latter is controlled for presenting the relaxation image (RB), a subfield of the sensor field (14) is read out with a readout clock rate which is higher than the camera clock rate provided for the complete readout of the sensor field (14).

7. Method according to Claim 6, wherein the subfield read out with the readout clock rate at least partially overlaps the trigger subfield (20).

8. Method according to any of Claims 5 to 7, wherein the camera (3, 13) is designed as a luminance measuring camera (13).

9. Method according to any of Claims 5 to 8, wherein the at least one further camera image (KB(RB)) is recorded within a predetermined temporal offset with respect to the ascertained start of relaxation ($t_R$).

10. Device comprising a control unit (2, 12) and a camera (3, 13), wherein the control unit (2, 12) is configured for controlling a pixel-by-pixel controllable optical display device (1), wherein the control unit (2, 12) and the camera (3, 13) are configured for carrying out a method according to any of Claims 4 to 6 and wherein the camera (3, 13) is designed as a complementary metal oxide semiconductor (CMOS) camera or as a charged coupled device (CCD) camera.

11. Device according to Claim 10, wherein the camera (3, 13) is configured for continuously determining the trigger characteristic value (T) from the at least one pixel value of the sensor pixels (15) in the trigger subfield (20) and for comparing the trigger characteristic value (T) with the trigger threshold value ($T_S$).

12. Application of a method according to any of Claims 5 to 9 for determining the burn-in behaviour of a display (1) provided for use in a vehicle.

**Revendications**

1. Procédé de détermination d'un début de la détente ($t_R$) lors de la commutation d'un dispositif d'affichage optique (1) pouvant être commandé au moyen d'une commande matricielle d'une image incrustée (EB') à une image de détente (RB), dans lequel

- dans l'image incrustée (EB'), une zone d'image de déclenchement (TB) comprenant au moins un pixel d'image est occupée par des valeurs de pixel de telle sorte qu'un premier paramètre établi par l'intermédiaire de ladite au moins une valeur de pixel dans la zone d'image de déclenchement (TB) de l'image incrustée (EB') se différencie d'un deuxième paramètre établi de la même manière par l'intermédiaire de ladite au moins une valeur de pixel dans la zone d'image de déclenchement (TB) de l'image de détente (RB),
- la distribution spatiale d'un niveau de gris correspondant à la distribution spatiale d'une grandeur caractéristique photométrique est détectée en continu dans le temps par l'intermédiaire du dispositif d'affichage (1) au moyen d'une caméra (3, 13) comprenant un champ de capteur (14) de pixels de capteur (15), la caméra (3, 13) étant conçue pour lire l'ensemble de tous les pixels de capteur (15) à une fréquence d'horloge de caméra et pouvant lire des sous-zones du champ de capteur (14) à une fréquence d'horloge plus élevée, dans lequel

    o un sous-champ de déclenchement (20) comprenant au moins un pixel de capteur (15) est défini de manière à chevaucher la zone d'image de déclenchement (TB) d'une image d'affichage (DB) représentée sur le dispositif d'affichage (1),
    o une valeur caractéristique de déclenchement (T) est déterminée en continu dans le temps dans le sous-champ de déclenchement (20) à une fréquence d'horloge de déclenchement à partir des valeurs de pixel dudit au moins un pixel de capteur (15),
    o dans lequel le sous-champ de déclenchement (20) est défini comme étant une sous-zone du champ de capteur (15) et étant lu à la fréquence d'horloge de déclenchement, et

- une valeur de seuil de déclenchement ($T_S$) est déterminée, celle-ci se situant entre la valeur caractéristique de déclenchement ($T$) obtenue pour l'acquisition de l'image incrustée (EB') et la valeur caractéristique de déclenchement ($T$) obtenue pour l'acquisition de l'image de détente (RB), et
- le début de la détente ($t_R$) est déterminé comme étant le moment où la valeur caractéristique de déclenchement ($T$) déterminée en continu dépasse la valeur de seuil de déclenchement (Ts), la fréquence d'horloge de déclenchement étant choisie supérieure à la fréquence d'horloge de caméra prévue pour la lecture de l'ensemble des pixels de capteur (15) du champ de capteur (14).

2. Procédé selon la revendication 1, dans lequel la valeur caractéristique de déclenchement (T) est détectée uniquement dans une plage temporelle de durée prédéterminée qui comprend le moment où la commande du dispositif d'affichage (1) est amenée à basculer de l'image incrustée (EB') à l'image de détente (RB).

3. Procédé selon la revendication 2, dans lequel une moyenne glissante est déterminée à partir d'une pluralité de valeurs caractéristiques de déclenchement (T) obtenues successivement, et est comparée à la valeur de seuil de déclenchement (Ts).

4. Procédé selon l'une quelconque des revendications précédentes, dans lequel les valeurs de pixel dans la zone d'image de déclenchement (TB) sont choisies de telle sorte qu'une première moyenne de valeurs de pixel dans la zone d'image de déclenchement (TB) de l'image incrustée (EB') soit supérieure à une deuxième moyenne de valeurs de pixel dans la zone d'image de déclenchement (TB) de l'image de détente (RB), et sont de préférence choisies de telle sorte que la luminance maximale pouvant être obtenue au moyen du dispositif d'affichage (1) soit obtenue au moins dans une sous-zone de la zone d'image de déclenchement (TB) de l'image incrustée (EB').

5. Procédé de détermination du comportement d'incrustation d'un dispositif d'affichage optique (1) pouvant être commandé pixel par pixel, dans lequel

   - le dispositif d'affichage (1), lorsqu'il n'a pas été soumis à un processus d'incrustation, est commandé pour représenter une image de référence (B0), dans lequel
   - une première image de caméra (KB(B0)) est acquise au moyen d'une caméra (3, 13), celle-ci permettant de détecter la distribution spatiale d'un niveau de gris correspondant à la distribution spatiale d'une grandeur caractéristique photométrique par l'intermédiaire du dispositif d'affichage (1), tandis que celui-ci est commandé pour représenter l'image de référence (B0),
   - le dispositif d'affichage (1) est commandé pour représenter une image incrustée (EB') pendant une durée d'incrustation prédéterminée,
   - le dispositif d'affichage (1) est commandé pour représenter une image de détente (RB), dans lequel

     o au moins un autre image de caméra (KB(RB)) est acquise au moyen de la caméra (3, 13), celle-ci permettant de détecter la distribution spatiale d'un niveau de gris correspondant à la distribution spatiale d'une grandeur caractéristique photométrique par l'intermédiaire du dispositif d'affichage (1), tandis que celui-ci est commandé pour représenter l'image de détente (RB), et
     o un début de la détente ($t_R$) est déterminé au moyen de la caméra (3, 13) conformément à un procédé selon l'une quelconque des revendications précédentes, et

   - le comportement d'incrustation est déterminé pour le dispositif d'affichage (1) à partir de la première image de caméra (KB(B0)), de ladite au moins une autre image de caméra (KB(RB)) ainsi que du début de la détente ($t_R$).

6. Procédé selon la revendication 5, dans lequel un sous-champ du champ de capteur (14) est lu à une fréquence de lecture qui est supérieure à la fréquence d'horloge de caméra prévue pour la lecture complète du champ de capteur (14) à partir de ladite au moins une autre image de caméra (KB(RB)) qui permet de détecter la distribution spatiale d'un niveau de gris correspondant à la distribution spatiale d'une grandeur caractéristique photométrique par l'intermédiaire du dispositif d'affichage (1), tandis que celui-ci est commandé pour représenter l'image de détente (RB).

7. Procédé selon la revendication 6, dans lequel le sous-champ lu à la fréquence de lecture chevauche au moins partiellement le sous-champ de déclenchement (20).

8. Procédé selon l'une quelconque des revendications 5 à 7, dans lequel la caméra (3, 13) est réalisée sous forme de caméra de mesure de luminance (13).

9. Procédé selon l'une quelconque des revendications 5 à 8, dans lequel ladite au moins une autre image de caméra (KB(RB)) est acquise avec un décalage temporel prédéterminé par rapport au début de la détente ($t_R$) déterminé.

10. Dispositif comprenant une unité de commande (2, 12) et une caméra (3, 13), dans lequel l'unité de commande (2, 12) est conçue pour commander un dispositif d'affichage optique (1) pouvant être commandé pixel par pixel, dans lequel l'unité de commande (2, 12) et la caméra (3, 13) sont conçues pour mettre en œuvre un procédé selon l'une quelconque des revendications 4 à 6, et dans lequel la caméra (3, 13) est réalisée sous forme de caméra de type Complementary Metal-Oxide Semiconductor (CMOS) ou de caméra de type Charged Coupled Device (CCD).

11. Dispositif selon la revendication 10, dans lequel la caméra (3, 13) est conçue pour déterminer en continu la valeur caractéristique de déclenchement (T) à partir de ladite au moins une valeur de pixel des pixels de capteur (15) dans le sous-champ de déclenchement (20) et pour comparer la valeur caractéristique de déclenchement (T) à la valeur de seuil de déclenchement *(Ts).*

12. Application d'un procédé selon l'une quelconque des revendications 5 à 9 pour déterminer le comportement d'incrustation d'un afficheur (1) destiné à être utilisé dans un véhicule.

EB

1

3

2

FIG 1

Stand der Technik

FIG 2

Stand der Technik

EP 3 923 266 B1

EB'

1

13

12

FIG 3

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 110376218 A
- US 20030214586 A1
- US 20070222860 A1

**In der Beschreibung aufgeführte Nicht-Patentliteratur**

- **ROTSCHOLL, INGO** ; **KRÜGER, UDO**. Aspects of Image Sticking Evaluations Using Imaging Luminance Measurement Devices. *SID Symposium Digest of Technical Papers*, 2019, vol. 50 (1), 695-698
- **LEE, DON-GYOU**. The Analysis Method of Dynamic Characteristics in LCD. *SID Symposium Digest of Technical Papers*, 2003, 292-295